Europäisches Patentamt

European Patent Office

Office européen des brevets

(19)

(11) **EP 0 594 517 B1**

(12) **FASCICULE DE BREVET EUROPEEN**

(45) Date de publication et mention
de la délivrance du brevet:
**20.01.1999 Bulletin 1999/03**

(51) Int Cl.6: **H03K 17/18**, H03K 17/08

(21) Numéro de dépôt: **93420408.2**

(22) Date de dépôt: **18.10.1993**

(54) **Dispositif avec circuit de détection de charge ouverte et transistor MOS de puissance**

Vorrichtung mit Schaltung zum Erkennen einer offenen Last und MOS Leistungstransistor

Device with open load detection circuit and power MOS transistor

(84) Etats contractants désignés:
**DE FR GB IT**

(30) Priorité: **21.10.1992 FR 9212903**

(43) Date de publication de la demande:
**27.04.1994 Bulletin 1994/17**

(73) Titulaire: **SGS-THOMSON MICROELECTRONICS S.A.**
**94250 Gentilly (FR)**

(72) Inventeurs:
• **Pavlin, Antoine**
**F-13540 Puyricard (FR)**
• **Siaudeau, Jean-Louis**
**F-13720 Belcodene (FR)**

(74) Mandataire: **de Beaumont, Michel**
**1bis, rue Champollion**
**38000 Grenoble (FR)**

(56) Documents cités:
**US-A- 5 079 456**

• **ELEKTRONIK, vol.39, no.17, 17 Août 1990, MüNCHEN, DE pages 103 - 107 DR. A. BLESSING ET AL. 'Intelligenter "Schalter" für DC- und PWM-Betrieb'**
• **ELEKTRONIK, no.7, 1991, MüNCHEN, DE pages 152 - 156 H. SAX ET AL. 'Smart-Power: verlustarme Steuerungs-Treiber'**

## Description

La présente invention concerne un circuit de détection de charge ouverte avec un transistor MOS de puissance en technologie verticale. Elle s'applique plus particulièrement à des composants dits "composants de puissance intelligents", fréquemment désignés dans la technique par l'appellation d'origine anglo-saxonne "Smart Power", qui comprennent sur une même puce semiconductrice un transistor MOS de puissance et des composants logiques.

Dans le cas de transistors MOS fonctionnant en commutation, c'est-à-dire à l'état bloqué ou à l'état pleinement passant sur une charge variable, par exemple une charge constituée de plusieurs charges en parallèle dont certaines sont sélectivement sélectionnées, il est utile pour l'utilisateur de disposer d'une indication du fait que la charge est éventuellement ouverte. Alors, même si le transistor de puissance est mis à l'état passant, aucun courant ne le traverse.

On rappelera également qu'un transistor MOS de puissance vertical, ou VDMOS, est constitué de très nombreuses cellules en parallèle ayant en commun leurs bornes de drain constituées par la face arrière de la pastille de silicium. Par contre, leurs bornes de source peuvent être connectées toutes ensembles ou par sous-groupes. Il en est de même pour leurs bornes de commande (bornes de grille).

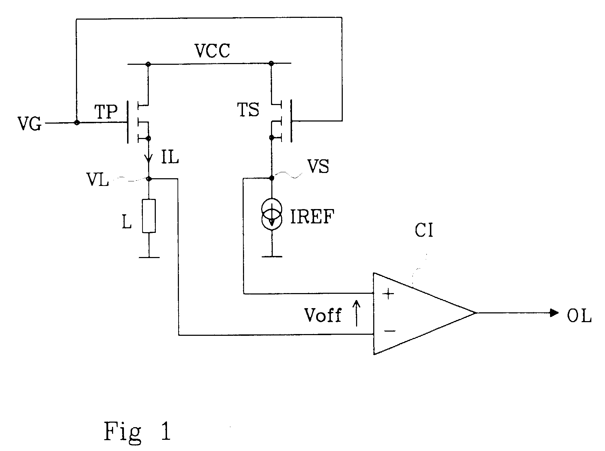

La figure 1 représente un circuit classique de détection de charge ouverte tel que décrit dans Elektronik, vol. 39, n°17, 17 août 1990, pages 103-107. Un transistor MOS de puissance TP est connecté par son drain à une borne d'alimentation haute VCC et par sa source à une charge L dont l'autre borne est reliée à une borne d'alimentation basse, généralement la masse. Un transistor de détection TS, constitué d'un petit nombre de cellules, identiques aux cellules du transistor principal, est également relié par son drain à la borne VCC. La source du transistor TS est reliée à la masse par l'intermédiaire d'une source de courant de référence IREF. La grille du transistor TS est reliée à la grille du transistor TP et reçoit une tension de commande VG. Les tensions aux bornes de source des transistors TP et TS, respectivement VL et VS, sont comparées dans un comparateur C1 qui fournit un signal d'alarme OL quand la tension de source du transistor TP devient inférieure à la tension de source du transistor TS, c'est-à-dire quand le courant IL dans la charge devient inférieur à un seuil $IL_0$.

En toute première approximation, en considérant que le transistor de puissance TP comprend Np cellules (par exemple 15 à 20 000) et que le transistor de détection TS comprend $N_s$ cellules (par exemple 10 à 25), le courant de seuil $IL_0$ est déterminé par la relation $IL_0 = (N_p/N_s)IREF$. Ainsi, en théorie, si IREF est choisi suffisamment petit, le seuil de détection peut être très bas. En effet, on cherche généralement à ce que ce seuil soit très faible pour distinguer le cas où le courant de charge est faible en raison du fait que la charge a une valeur élevée du cas où ce courant est faible ou nul du fait que la charge est ouverte ou endommagée.

En pratique, le comparateur C1, intégré sur la même puce que celle qui contient le composant de puissance, peut présenter une tension de décalage (couramment désignée dans la technique par l'appellation tension d'offset) non négligeable, par exemple comprise entre - et + 2 mV. Cette tension de décalage sera appelée ci-après Voff. En conséquence, la valeur minimum détectable de façon sûre entre les tensions de source VL et VS des transistors TP et TS est :

$$VL - VS = Voff. \qquad (1)$$

En appelant IL le courant dans la charge, RonP la résistance à l'état passant du transistor de puissance TP et RonS la résistance à l'état passant du transistor de détection TS, on peut écrire

$$VL = VCC - RonP.IL_0$$

$$VS = VCC - RonS.IREF$$

La formule (1) s'écrit alors

$$- RonP.IL_0 + RonS.IREF = Voff \qquad (2)$$

d'où

$$IL_0 = (RonS/RonP)IREF - Voff/RonP$$

en notant que $RonS/RonP = N_p/N_s$, on arrive à

$$IL_0 = (N_p/N_s)IREF - Voff/RonP. \qquad (3)$$

Ceci entraîne nécessairement que $(N_p/N_s)IREF$ doit être supérieur à Voff/RonP et donc que la limite inférieure de IL est :

$$IL_0 = 2Voff/RonP. \qquad (4)$$

Ainsi, le seuil minimal de détection est inversement proportionnel à la valeur de la résistance à l'état passant du transistor MOS de puissance TP. A titre d'exemple pratique, dans le cas où RonP = 0,05 ohm et Voff = 2 millivolts, le seuil minimal $IL_0$ a une valeur de 80 mA. Cette valeur est trop élevée dans de nombreux cas pratiques où l'on veut que ce seuil puisse être de l'ordre de 10 mA.

Pour résoudre ce problème, on a prévu dans la technique des circuits réalisant un asservissement de la tension de grille d'un transistor MOS de puissance sur la chute de tension aux bornes de ce transistor par une boucle de régulation linéaire. Ce procédé s'affranchit des problèmes du circuit précédemment décrit car le seuil de détection devient indépendant de la résistance à l'état passant du transistor de puissance et très peu sensible à la tension de décalage d'un comparateur de détection. Toutefois, ce procédé présente d'une part l'inconvénient de nécessiter un circuit plus complexe, d'autre part l'inconvénient lié à toute régulation linéaire à savoir une éventuelle instabilité de la boucle d'asservissement. En effet, dans le cas d'une charge inductive, il peut se produire au démarrage des oscillations sur la tension de charge. De même, dans le cas d'une charge capacitive, il peut se produire des oscillations de tension de grille par suite d'une déconnexion de la charge.

Ainsi, dans l'art antérieur, pour fournir un signal de détection de charge ouverte, on se trouve ou bien devant une solution, telle que celle représentée en figure 1, qui est simple et fiable mais qui présente inévitablement un seuil de détection relativement élevé, ou bien devant une solution relativement sensible mais complexe et susceptible d'être instable.

Un objet de la présente invention est de prévoir un circuit de détection de charge ouverte dont le seuil de détection puisse être particulièrement bas.

Un autre objet de la présente invention est de prévoir un tel circuit de détection de charge ouverte de structure simple et qui ne présente pas de risque d'instabilité.

Un autre objet de la présente invention est de prévoir un tel circuit de détection de charge ouverte qui ne modifie pas sensiblement la structure d'un transistor MOS de puissance vertical.

La présente invention prévoit essentiellement de faire fonctionner séparément deux groupes de cellules constituant le transistor de puissance, ces cellules étant connectées en parallèle par leurs bornes principales (drain et source) et séparément par leurs bornes de commande (grille) et de mettre en conduction en série avec la charge un seul groupe de ces cellules quand le courant de charge est faible. La résistance à l'état passant du transistor de puissance dans cette zone de faible courant est donc plus forte et, comme l'indique la formule (4) précédente, le seuil de détection peut augmenter même si on utilise un comparateur à tension d'offset variable dans une plage relativement étendue. On notera que le fait qu'un nombre limité seulement de cellules d'un transistor de puissance soit mis en conduction dans une phase de faible courant est sans inconvénient car, même si dans ce cas le transistor de puissance se trouve être plus résistif, le courant qui le traverse est alors par définition faible et la dissipation de puissance est en conséquence faible.

Plus particulièrement, la présente invention prévoit un dispositif comprenant un circuit de détection de charge ouverte et un transistor MOS de puissance destiné à fonctionner en commutation, dans lequel ce transistor MOS est divisé en deux transistors en parallèle, le deuxième transistor ayant une résistance à l'état passant plus élevée que celle du premier. Ce circuit comprend des moyens pour activer seulement le deuxième transistor quand le courant dans la charge est dans une plage de valeurs faibles, et des moyens de détection de charge ouverte tandis que l'on est dans la plage de valeurs faibles.

En d'autres termes, la présente invention prévoit un dispositif comprenant un circuit de détection de charge ouverte et un transistor MOS de puissance destiné à fonctionner en commutation et constitué d'un grand nombre de cellules connectées en parallèle entre une borne d'alimentation haute et une borne d'alimentation basse par rapport à une charge, dans lequel les cellules sont divisées en un premier et un deuxième groupe de cellules, les électrodes de commande du premier groupe de cellules étant reliées à une première borne de commande, les électrodes de commande des cellules du deuxième groupe de cellules étant reliées à une deuxième borne de commande, le nombre de cellules du deuxième groupe étant inférieur au nombre de cellules du premier groupe. Ce circuit comprend des moyens pour inhiber le fonctionnement du premier groupe de cellules quand le courant dans la charge se trouve dans une plage basse de valeurs, et des moyens de détection de passage du courant en dessous d'une valeur de seuil prédéterminée agissant tandis que l'on est dans la plage basse de valeurs de courant.

Selon un mode de réalisation de la présente invention, les moyens de détection de passage en dessous d'une valeur de seuil comprennent un petit nombre de cellules de même type que celles du transistor MOS de puissance connectées entre la borne d'alimentation haute et une source de courant reliée à la borne d'alimentation basse, et des moyens pour comparer les tensions de source du transistor de puissance et dudit petit nombre de cellules.

Selon un mode de réalisation de la présente invention, les moyens de détection du fait que l'on se trouve dans la première plage de courant comprennent un deuxième petit nombre de cellules connectées par leur drain à la borne d'alimentation haute et par leurs sources à une source de courant et des moyens pour comparer les tensions de source des cellules du transistor principal et des cellules du deuxième petit nombre de cellules.

Ces objets, caractéristiques et avantages ainsi que d'autres de la présente invention seront exposés en détail dans la description suivante de modes de réalisation particuliers faite en relation avec les figures jointes parmi lesquelles :

la figure 1 représente schématiquement un circuit de détection de charge ouverte selon l'art antérieur ;

la figure 2 représente un transistor de puissance composite selon la présente invention ;

la figure 3 illustre la caractéristique tension-courant d'un transistor de puissance composite selon la présente invention ;

la figure 4 représente un mode de réalisation d'un circuit selon la présente invention ;

la figure 5 représente un chronogramme destiné à illustrer le fonctionnement d'un circuit selon la présente invention ; et

la figure 6 représente plus en détail des circuits logiques adaptés à un circuit selon la présente invention.

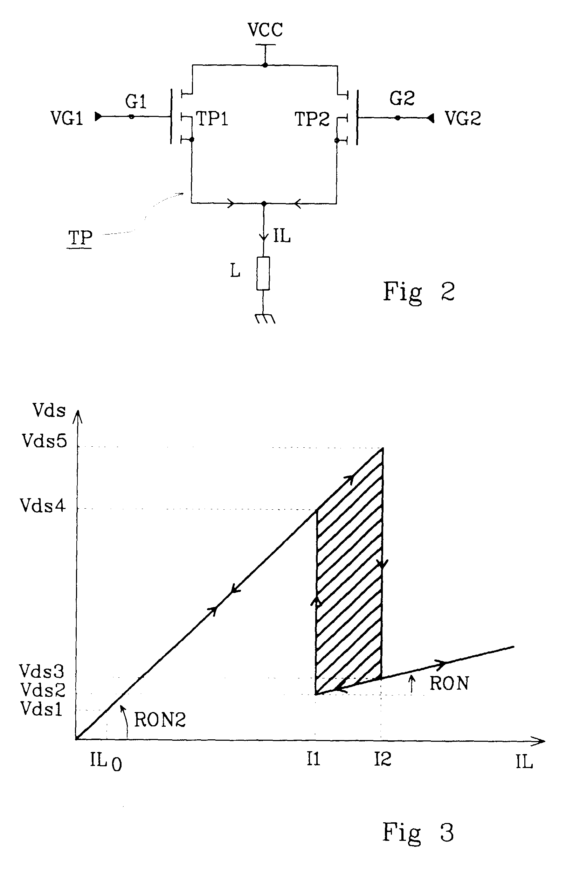

Comme le représente la figure 2, la présente invention propose d'utiliser un transistor principal composite TP constitué de deux groupes de cellules ayant un drain commun et une source commune. Le drain est connecté à une borne d'alimentation haute et la source à une charge dont l'autre borne est reliée à une borne d'alimentation basse, couramment la masse. Les grilles des cellules du premier groupe, qui sont les plus nombreuses et qui forment un transistor TP1, sont reliées à une première borne de commande G1. Les grilles du second groupe de cellules, qui forment un transistor TP2, sont reliées à une borne de commande G2. Les bornes de commande G1 et G2 sont actionnables séparément. On choisira de préférence pour le nombre N2 de cellules constituant le transistor TP2, un nombre 10 à 40 fois inférieur à celui du nombre N1 de cellules constituant le transistor TP1, par exemple 15 000 à 20 000 cellules pour le transistor TP1 et 500 à 2000 cellules pour le transistor TP2.

Selon l'invention, le transistor composite TP est commandé de sorte que, dans une première plage de courant, seul le transistor TP2 est mis en conduction et que, dans une deuxième plage de courant s'étendant au-delà de la première plage, les deux transistors TP1 et TP2 sont mis en conduction. La détection de charge ouverte, c'est-à-dire la détection du passage du courant de charge en dessous d'une valeur minimale est effectuée de la même façon que dans le cas de la figure 1. Mais alors, on se trouve nécessairement dans une plage de courant faible, c'est-à-dire que seul le transistor TP2 est dans un état de conduction. La résistance à l'état passant de ce transistor TP2 est élevée par rapport à la résistance d'ensemble du transistor composite. On peut donc mesurer des seuils X fois plus faibles que dans le cas du circuit de la figure 1, X étant égal au rapport entre le nombre N2 de cellules constituant le transistor TP2 et le nombre N1+N2 de cellules constituant l'ensemble des transistors TP1 et TP2. Avec les exemples de valeurs numériques indiqués précédemment, on peut donc atteindre des courants de seuil $IL_0$ 10 à 40 fois plus faibles qu'avec les circuits de l'art antérieur pour un transistor de puissance ayant dans son ensemble le même nombre de cellules.

La figure 3 illustre le mode de commande d'un transistor selon la présente invention. Elle représente la tension Vds aux bornes du transistor composite en fonction du courant dans la charge. Lors de la commande de mise en conduction du transistor composite, seul le transistor TP2 est mis en conduction et la caractéristique tension-courant a donc une pente égale à Ron2. Dès que le courant dans la charge atteint une valeur I2, la grille G1 du transistor TP1 est à son tour commandée et le transistor TP1 entre également en conduction. La pente tension/courant est alors égale à Ron (résistance à l'état passant de l'ensemble TP des transistors TP1 et TP2). Si le courant redescend au-dessous de la valeur I2, on effectue, pour une valeur du courant I1 légèrement inférieure à I2, une nouvelle commutation du transistor composite pour interrompre la mise en conduction du transistor TP1 et l'on a à nouveau un état de conduction du seul transistor TP2. Si le courant continue à décroître et chute en dessous d'une valeur $IL_0$ telle que déterminée par un comparateur similaire à celui de la figure 1, une indication de charge ouverte est fournie. On a désigné dans la figure par Vds1 la tension drain-source correspondant à $IL_0$, par Vds2 la tension correspondant au courant I1 pour laquelle le transistor TP1 cesse de conduire, par Vds3 la tension pour laquelle le transistor TP1 commence à conduire, par Vds4 la tension présente quand le transistor TP1 vient de cesser de conduire et que seul le transistor TP2 conduit, et par Vds5 la tension pour laquelle la commutation est effectuée du seul transistor TP2 vers l'ensemble des transistors TP1 et TP2. On notera qu'on a choisi une valeur I1 d'interruption de conduction du transistor TP1 inférieure à la valeur I2 de mise en conduction du transistor TP1 pour éviter des phénomènes d'oscillations parasites.

Pour faire fonctionner le système selon la présente invention, on prévoit des moyens pour détecter le fait que l'on atteint la tension Vds5 par valeur croissante, que l'on atteint la tension Vds2 par valeur décroissante et que l'on atteint la tension Vds1. On doit donc a priori associer au système selon la présente invention trois comparateurs/détecteurs de seuil. Néanmoins, dans un exemple de réalisation pratique exposé ci-après, on utilisera seulement deux comparateurs en choisissant Vds1 et Vds2 de valeurs égales et en prévoyant des circuits logiques propres à différencier les deux cas de passage par I1 ou par $IL_0$.

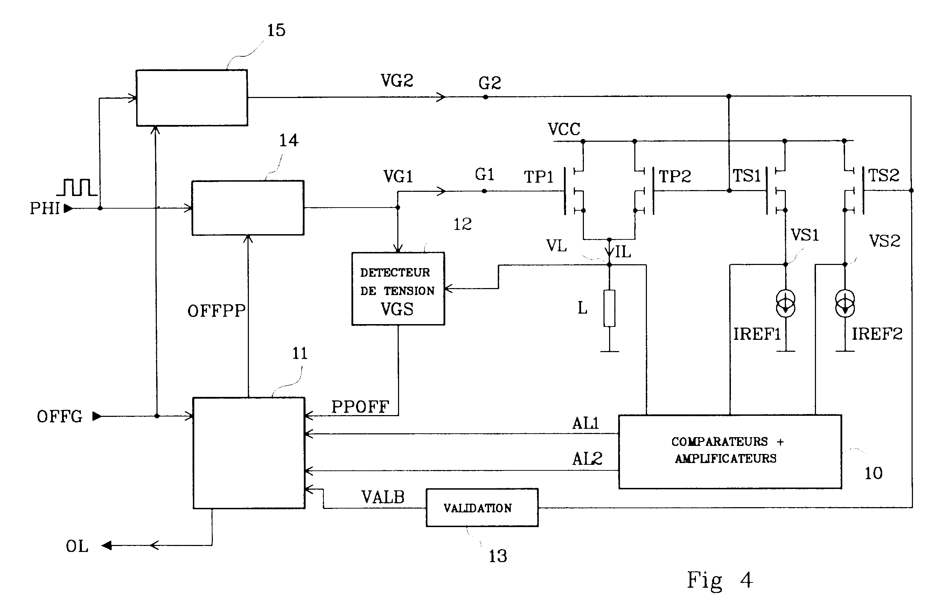

La figure 4 représente sous forme de blocs un transistor composite selon l'invention associé à des circuits logiques de commande et de détection.

On retrouve dans cette figure les transistors TP1 et TP2 dont les drains sont reliés à la tension VCC et les sources à une charge L dont l'autre borne est reliée à la masse. Des transistors de détection TS1 et TS2 constitués de cellules identiques à celles des transistors TP1 et TP2 mais en petit nombre sont reliés par leur drain à la tension haute VCC et par leur source à la masse par l'intermédiaire de sources de courant respectives IREF1 et IREF2. Un bloc comparateur et amplificateur 10 permet de comparer la tension VL au niveau des sources du transistor composite TP1-TP2 avec les tensions VS1 et VS2 respectivement présentes au niveau des sources des transistors de détection TS1 et TS2. Le bloc 10 fournit des signaux d'alarme AL1 et AL2 à un circuit logique 11.

Le signal d'alarme AL1 indique que le courant IL dans la charge est inférieur au seuil $IL_0$ quand seul le transistor TP2 fonctionne, ou bien que le courant IL est inférieur au seuil I1 lorsque l'ensemble du transistor composite fonctionne.

Le signal AL2 indique que le courant IL est inférieur au seuil I2 quand seul le transistor TP2 fonctionne.

Les signaux AL1 et AL2 sont envoyés à un circuit logique 11 qui reçoit par ailleurs un signal PPOFF en provenance d'un détecteur 12 de tension grille-source du transistor TP1. Ce signal PPOFF indique que le transistor TP1 est effectivement bloqué. Par ailleurs, il est prévu un bloc 13 de validation à la mise en conduction fournissant un signal VALB au circuit logique 11. Le circuit logique 11 reçoit aussi un signal OFFG de commande générale du dispositif et fournit d'une part un signal OFFPP d'inhibition d'un bloc de commande 14 de la grille G1 du transistor TP1, d'autre part un signal OL indiquant une charge ouverte. La référence 15 désigne un bloc de commande de la borne de gâchette G2 des transistors TP2, TS1 et TS2.

En supposant qu'un signal de commande en créneau, par exemple, arrive sur des blocs de commande de grille 14 et 15, au démarrage, quand le signal OFFG est émis, le bloc de commande 15 fournit un signal au rythme des créneaux aux transistors TP2, TS1 et TS2 tandis que le signal OFFPP inhibe le bloc de commande 14. C'est seulement après que le signal AL2 a commuté que le signal OFFPP commute et que le bloc de commande 14 déclenche une mise en conduction du transistor TP1. Inversement, quand le courant décroît, le signal AL1 déclenche dans un premier temps l'inhibition du bloc de commande 14 et, dans un deuxième temps la fourniture du signal OL.

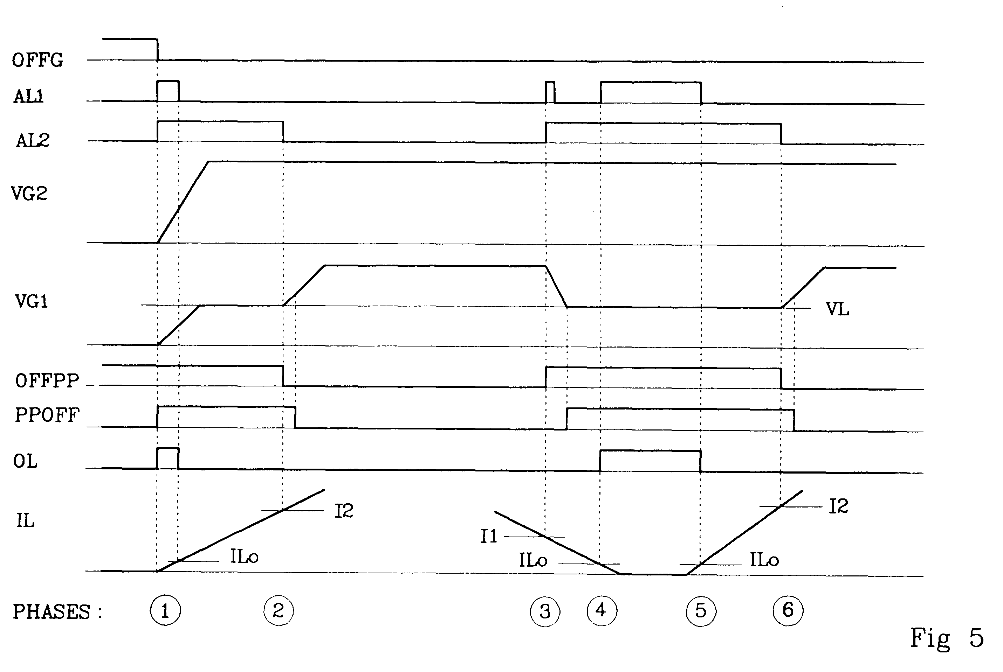

L'allure des divers signaux est représentée en figure 5 sous forme d'un chronogramme dans lequel on a illustré l'allure des signaux lors de six phases de fonctionnement successives.

Phase 1 : phase de démarrage normale du dispositif. Lorsque le composant est mis en marche, le signal OFFG tombe à 0 autorisant le démarrage du seul transistor TP2, le transistor TP1 restant bloqué par le signal OFFPP qui est actif. Le transistor TP2 étant commandé, sa grille monte en tension (VG2) et, par conséquent, le courant de charge IL commence à augmenter. L'alarme AL1 est active jusqu'à ce que le courant IL atteigne et dépasse le seuil $IL_0$, le signal OL est aussi actif jusqu'à ce que ce seuil soit atteint. L'alarme 2 est bien évidemment active car le courant IL n'a pas atteint le seuil I2.

Phase 2 : Le courant de charge IL continue d'augmenter et dépasse le seuil I2, l'alarme 2 tombe alors à 0 entraînant le démarrage du transistor TP1 par la chute à 0 du signal OFFPP. La tension de grille du transistor TP1 qui avait jusqu'alors suivi la tension de charge VL (VL - 2 chutes de tension de diodes en direct (VF) dans cette application) se met à augmenter et lorsque sa tension Vgs devient suffisamment positive, le signal PPOFF tombe à 0 indiquant que le transistor TP1 est réellement en activité. Le courant de charge IL circule alors dans les deux transistors TP1 et TP2.

Phase 3 : C'est la phase préliminaire à une détection de "charge ouverte" du dispositif en fonctionnement, les deux transistors étant en activité. Lorsque le courant de charge IL chute (charge déconnectée,...) et tombe en-dessous du seuil I1, l'alarme 1 devient active. Immédiatement, le transistor TP1 est coupé par le signal OFFPP et l'alarme 2 redevient active car lorsque les 2 transistors TP1 et TP2 sont passants, cette alarme est volontairement inhibée par un artifice logique. Le transistor principal TP1 étant coupé, sa tension grille VG1 chute, et lorsqu'elle devient négative par rapport à VL, le signal PPOFF est généré confirmant que le transistor TP1 est bien coupé. Le courant dans la charge ne circule plus que dans le transistor auxiliaire TP2. (L'alarme 1 retombe à 0 du fait que le transistor TP1 étant coupé, tout le courant de charge (sensiblement égal à I1) circule dans le transistor TP2).

Phase 4 : Le courant dans la charge continue de décroître et, lorsque le seuil $IL_0$ est atteint, l'alarme 1 redevient active et la détection de "charge ouverte" s'opère, le signal OL devenant actif.

Phase 5 : Equivalente à la Phase 1, sauf que VG2 est déjà stabilisé et que VG1 = VL - 2Vf de diode (dans cet exemple particulier).

Phase 6 : Similaire à la Phase 2.

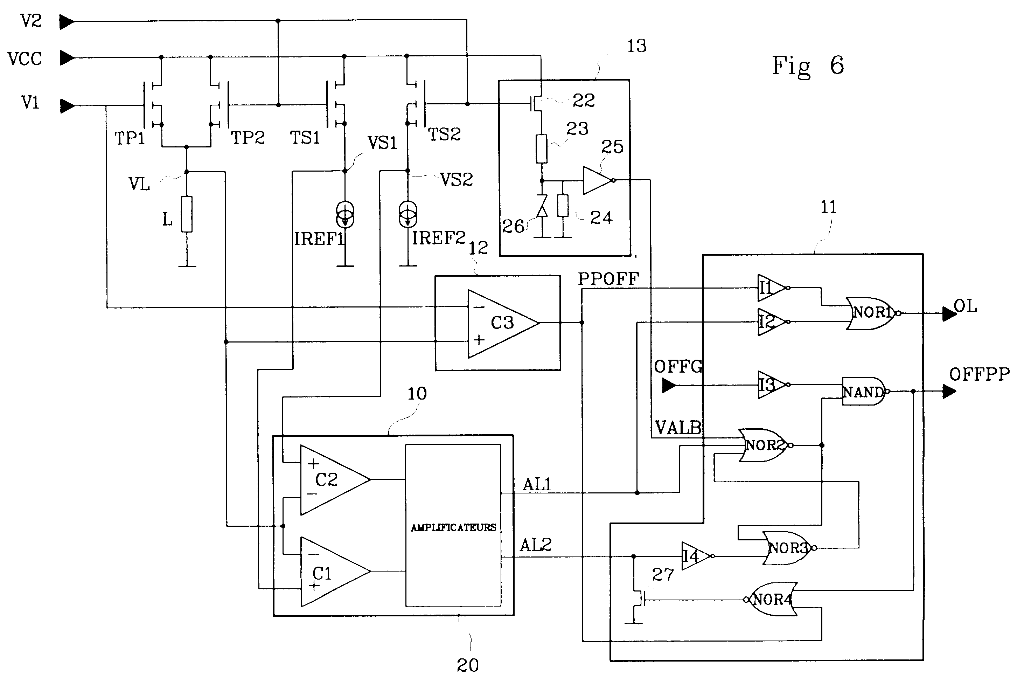

La figure 6 représente un exemple de réalisation pratique des schémas représentés sous forme de blocs en figure 4. De mêmes blocs ou éléments sont désignés par les mêmes références numériques.

Le bloc 10 comprend deux comparateurs C1 et C2 et des amplificateurs respectifs 20 désignés pour la commodité de la représentation par un bloc unique 20. Les sorties AL1 et AL2 sont croisées. Elles correspondent respectivement à la sortie du comparateur C1 et à la sortie du comparateur C2. Le comparateur C1 compare la tension VL à la tension VS1 et le comparateur C2 compare cette tension VL à la tension VS2. Le détecteur 12 de tension de grille du transistor TP1 compare la tension VL à la tension de grille G1 et fournit le signal PPOFF. Ainsi, les signaux AL1 et AL2 sont actifs si, respectivement, la tension VL est supérieure à VS1 et VS2 et la sortie PPOFF est active si VL est supérieure à VG1. Le bloc de validation 13 comprend un transistor MOS 22 en série avec des résistances respectives 23 et 24, le point de connexion des résistances 23 et 24 étant relié à un inverseur 25. Une diode zener de protection 26 est disposée en parallèle sur la résistance 24. La grille du transistor 22 est reliée à la borne G2. Ainsi, dès qu'un signal G2 est appliqué, l'entrée de l'inverseur 25 est amené à niveau haut et sa sortie VALB à niveau bas.

Le bloc logique 11 comprend des inverseurs I1 à I4, des portes NON OU, NOR1 à NOR4, et une porte NON ET, NAND, ainsi qu'un transistor MOS 27. La connexion de ces divers éléments est représentée dans la figure qui sera considérée comme faisant partie intégrante de la présente description. La sortie de la porte NOR1 fournit le signal OL et la sortie de la porte NAND le signal OFFPP. L'inverseur I1 reçoit le signal PPOFF, l'inverseur I2 le signal AL1, l'inverseur I3 le signal OFFG, la porte NOR2 les signaux VALB et AL1 ainsi que la sortie de la porte NOR3, l'inverseur I4 le signal AL2.

Quand le circuit est mis en route, le signal OFFG passe à zéro et le signal VG2 est fourni sur la grille G2. Avant même que ce signal VG2 ait eu une influence sur les grilles des divers transistors, le signal VALB est à 1 d'où il résulte que la porte NOR2 fournit nécessairement une sortie à 0 et la porte NAND dont l'autre entrée est à 1 fournit un signal à 1 qui confirme l'extinction du transistor TP1. Ensuite, dès que le signal a monté sur la borne G2, le signal VALB passe à 0 et la porte NOR2 peut commuter si ses autres entrées passent également à 0. Le circuit 13 a donc bien comme on l'a indiqué seulement pour fonction de fixer l'état initial de blocage du transistor TP1.

L'homme de métier pourra vérifier que le circuit logique 11 assure bien les fonctions souhaitées. Par exemple, dans une phase initiale de fonctionnement, tandis que le signal VG2 est appliqué, et alors que la tension VL est encore inférieure à VS1 et VS2 (IL est inférieur à $IL_0$) AL1 et AL2 sont à 1 et les sorties des portes NOR1 et NAND sont à 1. Dès que la tension VL devient supérieure à VS1, AL1 passe à 0 et la sortie de la porte NOR1 passe de 1 à 0 stoppant la fourniture du signal OL. Ensuite, quand la tension VS2 est dépassée, AL2 passe à 0 et la sortie de la porte NAND passe également à 0 d'où il résulte un arrêt de l'inhibition du transistor TP1. On pourra aussi vérifier que les autres phases souhaitées de fonctionnement du circuit sont satisfaites par le circuit logique 11.

A titre d'exemple, la demanderesse a réalisé un composant dans lequel le transistor TP1 comprenait 19400 cellules, le transistor TP2 comprenait 745 cellules, le transistor TS1 comprenait 10 cellules, et le transistor TS2 comprenait 2 cellules.

Le circuit détaillé illustré en figure 6 a seulement été décrit rapidement car il ne constitue qu'un mode de réalisation de la présente invention dont les aspects principaux ont été exposés précédemment et l'homme de métier pourra apporter diverses variantes et modifications au circuit sans sortir du domaine de l'invention tel que déterminé par les revendications.

## Revendications

1. Dispositif comprenant un circuit de détection de charge ouverte et un transistor MOS de puissance (TP) destiné à fonctionner en commutation, caractérisé en ce que ce transistor MOS est divisé en deux transistors (TP1, TP2) en parallèle, le deuxième transistor ayant une résistance à l'état passant plus élevée que le premier, en ce qu'il comprend des moyens pour activer seulement le deuxième transistor quand le courant dans la charge (L) est dans une plage de valeurs faibles, et en ce qu'il comprend des moyens (10) de détection de charge ouverte tandis que l'on est dans ladite plage de valeurs faibles.

2. Dispositif comprenant un circuit de détection de charge ouverte et un transistor MOS de puissance destiné à fonctionner en commutation et constitué d'un grand nombre de cellules connectées en parallèle entre une borne d'alimentation haute (VCC) et une borne d'alimentation basse par rapport à une charge (L), caractérisé en ce que lesdites cellules sont divisées en un premier et un deuxième groupe de cellules, les électrodes de commande du premier groupe de cellules étant reliées à une première borne de commande (G1), les électrodes de commande des cellules du deuxième groupe de cellules étant reliées à une deuxième borne de commande (G2), le nombre de cellules du deuxième groupe étant inférieur au nombre de cellules du premier groupe ; et en ce qu'il comprend :

des moyens pour inhiber le fonctionnement du premier groupe de cellules (TP1) quand le courant dans la charge se trouve dans une plage basse de valeurs ;
des moyens (10) de détection de passage du courant en dessous d'une valeur de seuil prédéterminée agissant tandis que l'on est dans ladite plage basse de valeurs de courant.

3. Dispositif selon la revendication 2, caractérisé en ce que les moyens de détection de passage en dessous d'une valeur de seuil comprennent un petit nombre de cellules (TS1) de même type que celles du transistor MOS de puissance connectées entre la borne d'alimentation haute et une source de courant (IREF1) reliée à la borne d'alimentation basse, et des moyens (C1) pour comparer les tensions de source du transistor de puissance et dudit petit nombre de cellules.

4. Dispositif selon la revendication 3, caractérisé en ce que les moyens de détection du fait que l'on se trouve dans la première plage de courant comprennent un deuxième petit nombre de cellules (TS2) connectées par leur drain à la borne d'alimentation haute et par leurs sources à une source de courant (IREF2) et des moyens (C2) pour comparer les tensions de source des cellules du transistor principal et des cellules du deuxième petit nombre de cellules.

## Patentansprüche

1. Schaltungsvorrichtung mit einer Detektorschaltung zur Detektion bzw. zum Nachweis einer offenen Last (eines Offen-Last-Zustands, Freilauf-Last-Zustands) und einem zum Betrieb als Schalter vorgesehenen MOS-Leistungstransistor (TP),
dadurch gekennzeichnet, daß der MOS-Transistor in zwei parallel liegende Transistoren (TP1, TP2) unterteilt ist, wobei der zweite Transistor einen höheren Durchlaßwiderstand als der erste aufweist, des weiteren dadurch gekennzeichnet, daß die Vorrichtung Mittel zur Aktivierung nur des zweiten Transistors aufweist, wenn der Strom in der Verbraucherlast (L) in einem Bereich niedriger Werte liegt, und daß sie Mittel (10) zur Detektion bzw. zum Nachweis eines Offen-Last-Zustands aufweist, wenn die Schaltung sich in dem genannten Bereich niedriger Werte befindet.

2. Schaltungsvorrichtung, welche umfaßt: eine Detektorschaltung zur Detektion bzw. zum Nachweis eines Offen-Last-Zustands (Zustands mit offener Last, Last-Leerlauf-Zustands) und einen zur Betriebsweise als Schalter bestimmten MOS-Leistungstransistor, der aus einer großen Anzahl von zwischen einem hohen Speisespannungsanschluß (VCC) und einem niedrigen Speisespannungsanschluß in Parallelanordnung bezüglich einer Last (L) liegenden Zellen besteht,
dadurch gekennzeichnet, daß die genannten Zellen in eine erste und eine zweite Zellengruppe unterteilt sind, wobei die Steuerelektroden der ersten Zellengruppe mit einem ersten Steueranschluß (G1) und die Steuerelektroden der Zellen der zweiten Zellengruppe mit einem zweiten Steueranschluß (G2) verbunden sind und die Anzahl der Zellen der zweiten Gruppe kleiner als die Anzahl der Zellen der ersten Gruppe ist, und daß die Vorrichtung umfaßt:

   - Mittel zur Inhibierung der Funktion der ersten Zellengruppe (TP1), wenn der Strom in der Verbraucherlast sich in einem niedrigen Wertebereich befindet;
   - Detektormittel (10) zur Feststellung, wenn der Strom einen vorgegebenen Schwellwert unterschreitet, wobei diese Detektormittel während des Betriebs in dem genannten niedrigen Wertebereich von Strömen wirksam sind.

3. Schaltungsvorrichtung nach Anspruch 2,
dadurch gekennzeichnet, daß die Detektorschaltmittel zum Nachweis der Unterschreitung eines Schwellwerts eine kleine Anzahl von Zellen (TS1) vom gleichen Typ wie die Zellen des MOS-Leistungstransistors in Schaltverbindung zwischen dem hohen Speiseanschluß und einer mit dem niedrigen Speiseanschluß verbundenen Stromquelle (IREF1) aufweisen, sowie Schaltmittel (C1) zum Vergleich der Source-Spannungen des Leistungstransistors und der genannten kleinen Anzahl von Zellen.

4. Schaltungsvorrichtung nach Anspruch 3,
dadurch gekennzeichnet, daß die Detektorschaltmittel zur Feststellung des Zustands in dem ersten Strombereich eine zweite kleine Anzahl von Zellen (TS2) umfaßt, die mit ihrem Drain-Anschluß mit dem hohem Speiseanschluß und mit ihrenSource-Anschlüssen mit einer Stromquelle (IREF2) verbunden sind, sowie Schaltmittel (C2) zum Vergleich der Source-Spannungen der Zellen des Haupttransistors und der Zellen der zweiten kleinen Anzahl von Zellen.

## Claims

1. A device comprising a circuit for detecting an open load and a power MOS transistor (TP) designed to operate in a switching mode, characterized in that said MOS transistor is divided into two transistors (TP1, TP2) disposed in parallel, the second transistor having a resistance in the conductive state higher than the first one, in that it comprises means for enabling only the second transistor when the current in the load (L) is within a low value range, and in that it comprises means (10) for detecting an open load when the circuit is operating within said low value range.

2. A device comprising a circuit for detecting an open load and a power MOS transistor designed to operate in a switching mode and formed by a large number of cells that are coupled in parallel between a high supply voltage $V_{cc}$ terminal and a low supply voltage terminal with respect to a load (L) characterized in that said cells are partitioned into a first and a second group of cells, the control electrodes of the first group of cells being connected to a first control terminal (G1), the control electrodes of the cells of the second group of cells being connected to a second control terminal (G2), the number of cells in the second group being smaller than the number of cells in the first group; and in that it includes:

   means for inhibiting operation of the first group of cells (TP1) when the load current is within a low value range; and
   means (10) for detecting a load current lower than a predetermined threshold value, said means being operative within said low current range.

3. The device of claim 2, characterized in that said means for detecting a current lower than a predetermined threshold value include a small number of cells (TS1) similar to those of the power MOS transistor and that are connected between the high supply voltage terminal and a current source (IREF1) that is connected to the low supply voltage terminal, and means (C1) for comparing the source voltage of the power transistor with the source voltage of said small number of cells.

4.  The device of claim 3, characterized in that said means for detecting the fact that the circuit operates within the low current range include a second small number of cells (TS2) that are connected by their drain to the high supply voltage terminal and by their sources to a current source (IREF2), and means (C2) for comparing the source voltage of the cells of the main transistor with the source voltage of the cells of the small number of cells.

Fig 1

VCC

VG1 ▶ G1 ·  TP1    TP2  G2 · ◀ VG2

TP

↓ IL

L

Fig 2

Vds

Vds5

Vds4

Vds3
Vds2
Vds1

RON2

↑ RON

IL₀    I1   I2    IL

Fig 3

Fig 4

Fig 5

OFFG
AL1
AL2
VG2
VG1
OFFPP
PPOFF
OL
IL

VL

I2
I1
ILo
ILo
I2
ILo

PHASES : ① ② ③ ④ ⑤ ⑥

EP 0 594 517 B1

12

Fig 6

EP 0 594 517 B1